Europäisches Patentamt

European Patent Office

Office européen des brevets

(11) Publication number: **0 415 191 A1**

# EUROPEAN PATENT APPLICATION

(21) Application number: 90115689.3

(51) Int. Cl.⁵: **C30B 25/14, C23C 16/44**

(22) Date of filing: 21.08.90

(30) Priority: 31.08.89 IT 2158289

(43) Date of publication of application:
06.03.91 Bulletin 91/10

(84) Designated Contracting States:
AT BE CH DE DK ES FR GB GR IT LI LU NL SE

(71) Applicant: LPE SPA
Via Stella Rosa (Head Office)
I-20021 Ospiate di Bollate Milano(IT)

(72) Inventor: Pozzetti, Vittorio
Via Volturno, 80
I-20047 Brugherio, Milano(IT)
Inventor: Vasco, Aurino
Via Muggina, 21
CH-6962 Viganello, Lugano(CH)

(74) Representative: Michelotti, Giuliano et al
c/o SAIC BREVETTI S.r.l. Viale Bianca Maria
15
I-20122 Milano(IT)

(54) **System for controlling epitaxial grow rate in vertical provided with a frustum pyramid susceptor.**

(57) System is disclosed for controlling the epitaxial growth rate in reactors (110) provided with a belljar (112) containing a frustum pyramid susceptor (132). To obtain a uniform flow of reactive gas across the lateral faces of the susceptor, protrusions or ridges (147a-g) extend from the edges separating the lateral faces (146a-g) of the susceptor (132).

Fig.8

# SYSTEM FOR CONTROLLING EPITAXIAL GROW RATE IN VERTICAL REACTORS PROVIDED WITH A FRUSTUM PYRAMID SUSCEPTOR

The present invention relates a system for controlling the epiaxial grow rate in vertical reactors, provided with a frustum pyramid susceptor, by controlling a flow rate of reacting gases around said susceptor.

Vertical epitaxial reactors essentially consisting in a susceptor, or heated carrier, contained in a belljair, housing or supporting bodies to be chemically treated, such as slices of crystalline semiconductor materials to be epitaxially grown, are well known.

There is a first kind of reactors receiving reacting gases from a plurality of ducts, located at an end of the belljair, at a relatively high speed and discharging them near an upward faced dome through an exhaust pipe, inducing a gas circulation from upside to downside at a side of the belljair and a partial but substantial upreturn of reacting gases at the opposite side of the belljair. A rotation of the susceptor contained in the belljair permits to substantially uniformly expose the bodies, to be treated, to said reacting gases.

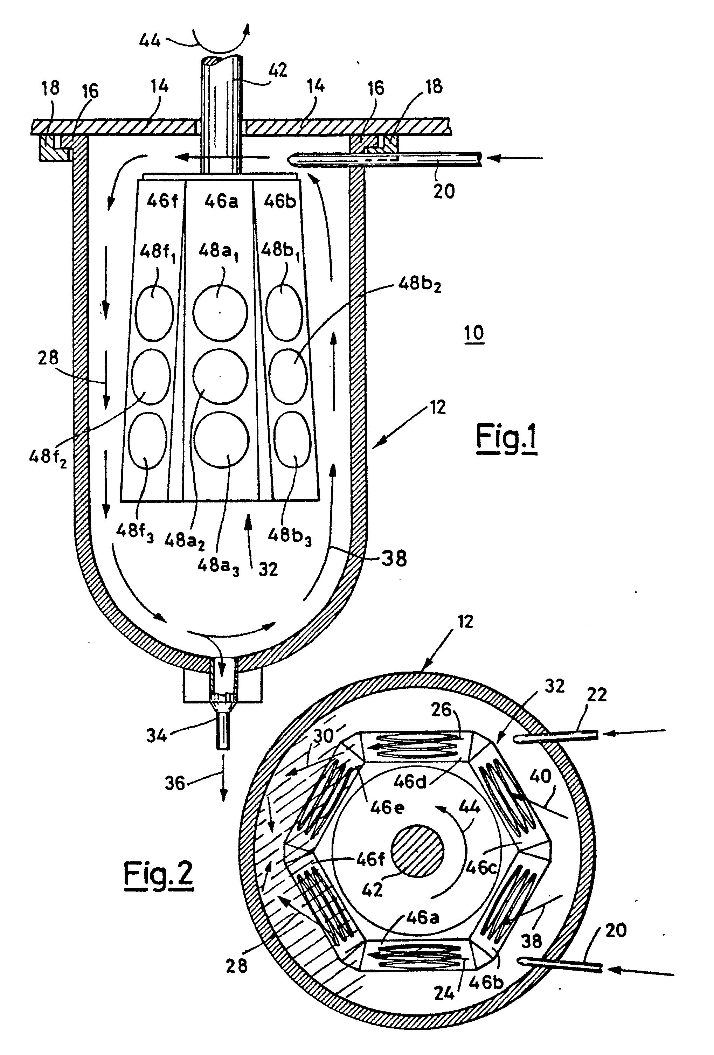

This first kind of reactors shows advantages and disadvantages which are herebelow discussed in the detailed description referring to figures 1 and 2.

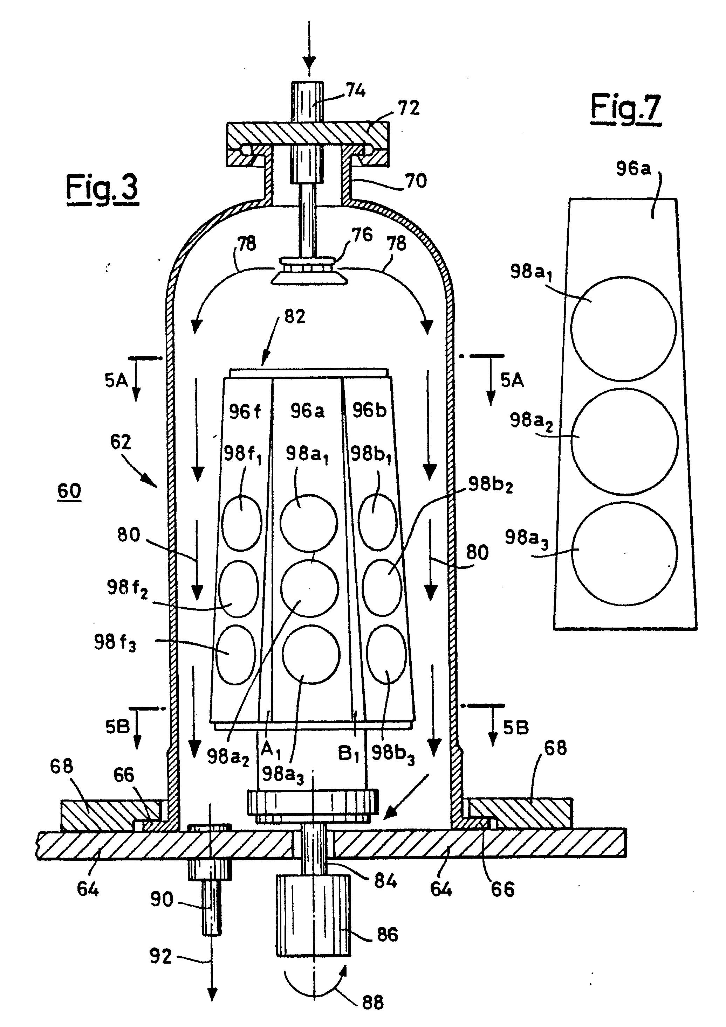

In a second kind of reactors, as herebelow more in detail described with reference to figures 3 to 7, the fresh reacting gases are uniformly distributed in the whole belljair in order to contemporaneously move from upside to downside along all the lateral walls of the susceptor.

This kind of reactors, receiving the reacting gases in a uniform way all around the lateral walls, shows advantages and disadvantages which are herebelow discussed with reference to figures 3 to 7.

It is an object of the present invention to avoid the problems connected with epitaxial grow variations due to the prior art solutions of the above depicted reactor kinds.

To this purpose, there has been devised a system for controlling the epitaxial grow rate in reactors of the above mentioned kind using a frustum pyramid susceptor, contained in a belljair, through the control of the flow rate of reacting gases around said susceptor, characterized in that it is tried to make the most uniform the possible said flow rate on lateral faces of said susceptor through the use of solid obstacles in the form of corner ridges protruding from said lateral corners defined by adjacent faces of said susceptor.

Particularly, said system is characterized in that a frustum pyramid susceptor is provided with protrusions or ridges integrally made into the bulk of said susceptor excavating, by means of planar milling, planar faces along the lateral suface of a truncated cone consituting the starting piece of said susceptor.

Otherwise, the above mentioned subsantially frustum pyramid susceptor is obtained by lateral milling curved faces on a substantially frustum cone starting piece for obtaining protruding integral ridges.

Alternatively, this system for subsantially stopping the reacting gas flow near corners delimiting lateral faces of frustum pyramid susceptors uses protrusions or ridges at said corners separating said lateral faces.

According to a second embodiment, said system uses a frustum pyramid susceptor provided near any corner separating adjacent lateral faces with pairs of protrusions or ridges delimiting said faces and inserted in slots dug into the lateral faces themselves.

Alteratively, a frustum pyramid susceptor is provided, near any corner separating lateral faces, with protrusions or ridges provided with further lateral protrusions parallel to said lateral faces to enhance the flow rate uniformity of reacting gases along said lateral faces of the susceptor, said protrusions being located at the corner separating the faces.

Further alternatively, a frustum pyramid susceptor is provided near any corner separating adjacent lateral faces with pairs of protrusions or ridges, delimiting said faces, provided with lateral protrusions parallel to said faces for enhancing the flow rate uniformity of the reacting gases along said lateral faces of the susceptor, said of protrusions being located at the lateral faces themselves.

Particularly, said protrusions or ridges are arranged with their external edges parallel to the corresponding corners separating lateral faces of the said frustum pyramid susceptor. Otherwise, said protrusions or ridges coming out from the corners separating the lateral faces of said susceptor are of variable thickness so that their external edges remain parallel to the susceptor axis and to the lateral wall of the belljair.

Lastly alternatively, said protrusions or ridges coming out from the corners separating the lateral faces of said susceptor are provided with an external and variously shaped edge.

The features and the advantages of the present inention will be made more apparent by the following detailed specification comparing frustum pyramid susceptors of the prior art with embodiments of susceptors according to the present invention, not to be considered in a limiting way, provided with the enclosed drawings, wherein:

figure 1 is a lateral sectional view of an epitaxial reactor of the prior art, provided with a top open belljair;

figure 2 is a schematical sectional top view of an epitaxial reactor of the kind shown in figure 1;

figure 3 is a lateral sectional view of a vertical reactor provided with a bottom open belljair;

figure 4 is a top view of an epitaxial reactor, of the kind shown in figure 3, depicting a reacting gas distribution pattern into the same;

figure 5A is a partial view along the 5A-5A in figure 3, depicting the delimitation of flowing gas channels between susceptor faces and belljair at the top of the susceptor;

figure 5B is a patial view along line 5B-5B in figure 3, depicting the delimitation of flowing gas channels between the faces of the susceptor and the belljair at the bottom of said susceptptor;

figure 6A depicts a flow rate profile of reacting gases along a parallel adjacent the the top of a reactor susceptor of figure 3;

figure 6B depictes a flow rate profile of reacting gases along a parallel adjacent the bottom of the same susceptor;

figure 7 is a schematical view of a lateral face of a frustum pyramid susceptor in a vertical epitaxial reactor of the kind in figure 3;

figure 8 is a partial view, in lateral elevation, of an epitaxial reactor, provided with a susceptor according to the invention, permitting to control the reacting gas distribution and thus the grow rate in the reactor itself;

figure 9A is a partial view, along the line 9A-9A in figure 8, depicting the delimitation of gas flow channels among susceptor faces and belljair at the top of said susceptor;

figure 9B is a partial view, along line 9B-9B in figure 8, depicting the delimitation of gas flow channels among susceptor faces and belljair at the bottom of said susceptor;

figure 10A depicts a reacting gas flow rate profile along a parallel adjacent the top of the susceptor;

figure 10B depictes a reacting gas flow rate profile along a parallel adjacent the bottom of the susceptor;

figures 11 and 12 are top views of susceptors, according to the invention, provided with corner protrusions or ridges integrally formed in the material of the susceptors;

figures 13 and 14 are top views of susceptors, according to tjhe invention, provided with inserted protusions or ridges;

figures 15 and 16 are top views of susceptors according to the invention having inserted protrusions or ridges provided with transversal plates pointing to the center of any lateral face for determining conveying areas for the reacting gases along said faces;

figure 17 is a lateral partial view of a susceptor provided with ridges having edge parallel to a lateral corner;

figure 18 is a lateral partial view of a susceptor provided with ridges having edge parallel to a centerline;

figure 19 is a lateral partial view of a susceptor provided with ridges having variously shaped edge.

Referring now to figures 1 and 2, it is to see tha an epitaxial reactor 10 is generally consisting of a belljair 12, usually of quartz or similar transparent and chemical reactant resistant materials, suspended to a support plane 14 against which is engaged by a flange 16 held by means of fastening blocks 18.

At the top the belljair 12 is provided with nozzles 20 and 22 for inputting reacting gases to convey said reacting gases according to jets indicated by respective arrows 24 and 26 and producing gas flows 28 and 30 circulating around a frustum pyramid 32 housed in said belljair 12.

A drain pipe 34, located on the curved dome bottom of the belljair, provides a drain for exhausted reacting gases, coming out from it as a flow 36, while part of said exhausted gases ricirculates in the belljair as flows 38 and 40, mixiing with the fresh reacting gases conimg in through the nozzles 20 and 22.

Said susceptor 32 is hanged in the belljair 12 by means of a shaft 42 allowing also the rotation thereof, for example in the direction of the arrow 44.

As usual, the frustum pyramid susceptor 32 is provided with lateral faces 46a-f housing slices $48a_1$-$a_3$, $48b_1$-$b_3$, ..., $48f_1$-$f_3$ of material to be treated.

Referring to figures 3 to 5A-5B, it is to see that an epitaxial reactor 60 is generally consisting of a belljair 62, usually of quartz or similar transparent and chemical reactant resistant materials, resting on a support plane 64 on which is engaged by means of a flange 66 held by fastening blocks 68.

At the top the belljair 62 is povided with a neck 70 closed by a flange 72 through which passes a pipe 74 for inputting reacting gases, ending with a circular diffuser and distributor 76, from which gas jets, such as those indicated by the arrows 78, come out. Said gas jets pass as gas flows 80 through gaps between the lateral walls of the belljair 62 and lateral surfaces or faces of a frustum pyramid susceptor 82, made rotatable by means of a shaft 84 actuated by a motor 86, for eaxmple in the direction indicated by an arrow 88, and are drained as exhausted gases through a drain pipe 90 as an output flow 92. According to the first system for imputting reacting gases used in the epitaxial reactor 10 depicted in figures 1 and 2, the reacting gases coming in through the nozzles 20 and 22, are compressed in the hatched areas, indicated by the arrows 28 and 30, wherein they they flow at a speed well higher than that present in other areas of the reactor, so that in these areas the growing rate of the slices 48 is also five times higher than the average rate detected at the end of process. Of course, the rotaion of the susceptor 32 around its vertical axis or centerline insures a uniform distribution of growing rate on all the faces of the susceptor.

As already above explained, with this system there is some mixing of fresh just input reacting gases with already partially reacted gases not allowing a particarly carefull control of some electrical parameters of the deposited layer. Further, as the inputting flow rate of the gases is very high, is also very high the instantaneous growing rate of the epitaxial layer in the area where the ject is directed, providing to produce solid particles (dust), inducing crystallographical or lattice defects in the epitaxial layer grown on the slice.

Further, as the instantaneous grow rate of the epitaxial layer is high, said grow rate is damaging for specific devices, such as buried layer devices, because it produces distorsions in images of the layers under the epitaxial layer and problems in the succeding production processes. In this system, by properly pointing the nozzles 20 and 22, it is possible to modify the grow rate of the epitaxial layer in favour of some more uniformity along the parallel of the suscseptor, i. e. in horizontal direction.

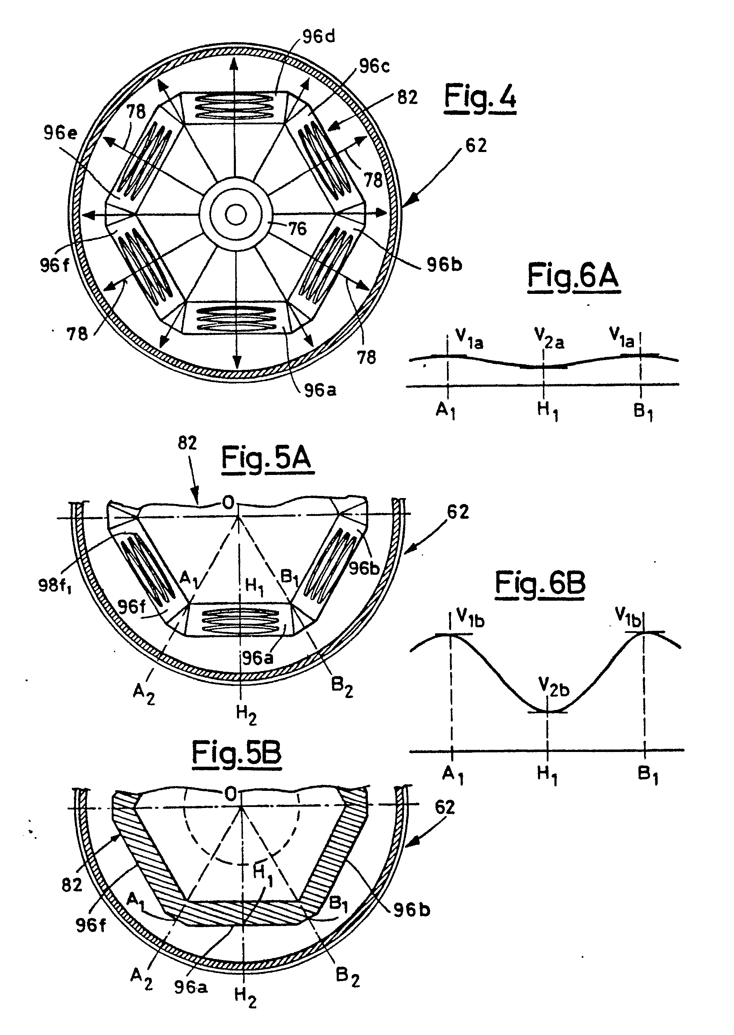

The above mentioned problems are avoided in the epitaxial reactor 60 depicted in figures 3 to 5A, 5B using a second gas inputting system consisting of an admitting pipe 74 connected to a circular diffuser and distributor 76 distributing said gas in a theoretically uniform way on the whole section of the gap existing between the belljair 62 and the susceptor 82, as indicated by jets 78 and gas flows 80 in the figures 3 and 4.

Of course, this system avoids mixing between fresh and exhausted reacing gases and does not produce any dust, eliminating the specific problems here above specified for the reactor 10 depicted in figures 1 and 2 and further allows a uniform instantaneous grow rate along the susceptor meridians which is similar to the average rate detected at the process end; this fact is particlarly advantageous for the above mentioned buried layer devices and offers a better control of the electrical parameters of the epitaxial layer.

This second system, allowing to obtain a good uniformity in the grow rate along the vertical axis of the susceptor 82 itself, however does not have means to modify the grow distribution (and thus the grow thickness on the slices) along the parallels of the susceptor 82.

Presently the flow rates of the gases in the gap between belljair 62 and susceptor 82 is about inversely proportional to the thickness thereof, so that this rate is the highest near the corners of the susceptor 82 and the lowest near the central axis of any face of the susceptor, consequentely also the growing rate, which is strongly dependent on the flow rate of the gases, is similarly variable.

This fact is particularly understood looking at figures 5A, 5B, and 6A, 6B from which the thicknesses of said gap at the top and the bottom of the susceptor 82 and the corresponding flow rate of the gases near the corners and the center of any face of the susceptor can be appreciated.

The above mentioned reasons are better understood just looking at the figures 5A, 6A and 5B, 6B. Referring to figure 5A, partially depicting a cross-section of the reactor 60 taken along the line 5A-5A of figure 3, it is to see that between the lateral wall of the belljair 62 and the susceptor 82 there is a gap whose thickness variates from a minimum, corresponding to the differences of the radii $OA_2$, $OA_1$ and $OB_2$, $OB_1$, to a maximum corresponding to the difference of the radii $OH_2$ and $OH_1$.

As the flow rates of the gases are about inversely proportional to said gap thicknesses, it results that said rates variate substantially as indicated in the diagramm of figure 6A, wherein at the points $A_1$ and $B_1$ there is the maximum flow rate $V_{1a}$ and at the point $H_1$ there is the minimum rate $V_{2a}$.

The ratio between said rates $V_{1a}$ and $V_{2a}$ is very near to the unit, because the gap thicknesses at the corners are almost equal to the gap thickness at the center of any face of the susceptor.

Referring to figure 5B, partially depicting a cross-section of the reactor 60 taken along the line 5B-5B of figure 3, it is to see that between the lateral wall of the belljair 62 and the susceptor 82 there is a gap whose thickness variates from a minimum, corresponding to the differences of the radii $OA_2$, $OA_1$ and $OB_2$, $OB_1$, and a maxinum corresponding to the difference of the radii $OH_2$ and $OH_1$.

The corresponding flow rates of the gases in the gap are depicted in figure 6B, wherein it is to see that at the points $A_1$ and $B_1$ there is the maximum rate $V_{1b}$ and at the point $H_1$ there is the minimum rate $V_{2b}$, however in the present case, differently from what happens in figure 6A, the ratio between maximum and minimum rate is more enhanced, because the ratio between minimum and maximum gap thickness is higher.

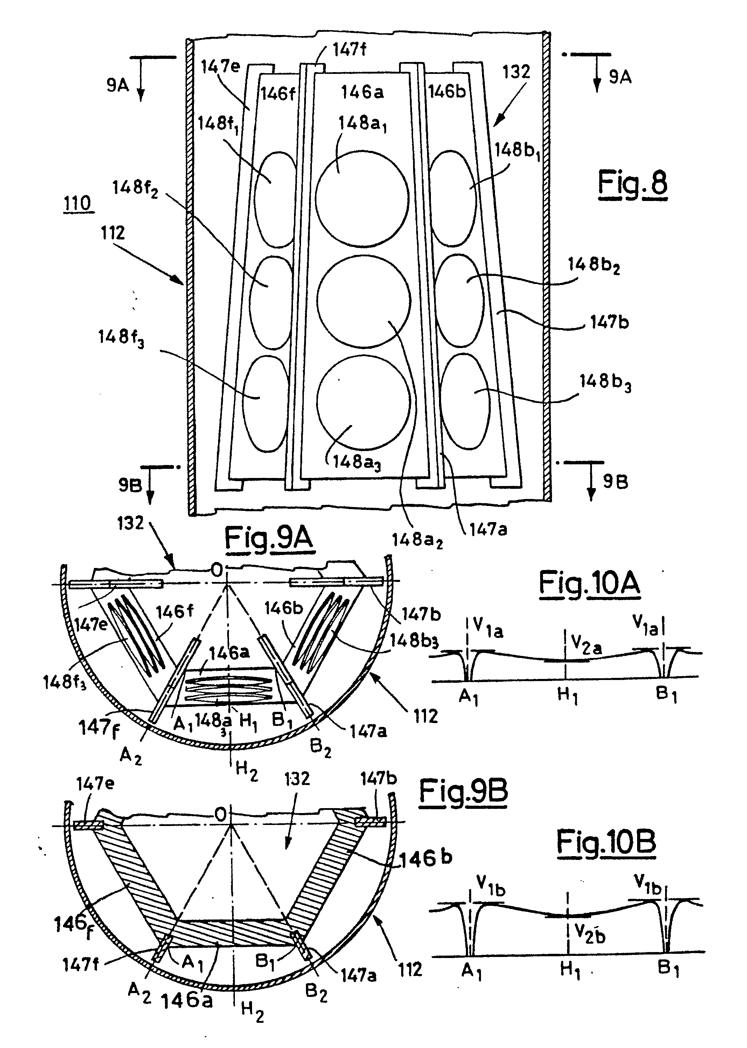

These differences in flow rates along the parallels of the susceptor translate into different thickness in epitaxial layers deposited on slices, as depicted in figure 7, showing a face 96a of the susceptor 82 housing three semiconductor disks or slices $98a_1$, $98a_2$ and $98a_3$. As visible in said figure 7, the slices $98a_1$, $98a_2$ and $98a_3$ on average undergo a higher grow (indicated by the symbol +) along the edges adjacent the lateral corners of the face 96a and a reduced grow (indicated by the symbol-) along a diametral central area thereof. Said grow differences depicted in figure 7 cannot even be compensated by rotation of the susceptor 82 into the belljair 62 because, apart from minor casual flow rate variations of the gases in the belljair due to shape irregulrities thereof, a rotation of the susceptor 82 with respect to the belljair 62 should not imply any gap thickness variation and then no gap variations by rotation and flow rate and deposition thickness uniformation along the parallels of the susceptor 82 can be expected. Thus according to this second system of gas introduction cannot be avoided variations in grown layers thickeness, as depicted in figure 3.

To avoid the above depicted problems, resort is to be made to a susceptor according to the invention, such as that depicted in figure 8.

In said figure 8, an epitaxial reactor 110 comprises a belljair 112 containing a frustum pyramid susceptor 132 whose lateral faces l46a-f are provided with protrusions or ridges 147a-f coming out in radial direction from the corners separating the lateral faces themselves. As in the prior art, said lateral faoes 146a-f house disks or slices$148a_1$-$a_3$, $148b_1$-$b_3$, ...., $148f_1$-$f_3$ of material to be treated.

It has been experimentally asoertained that the presence of said ridges 147a-f makes more uniform the epitaxial grow rate along the parallels of the susceptor 132.

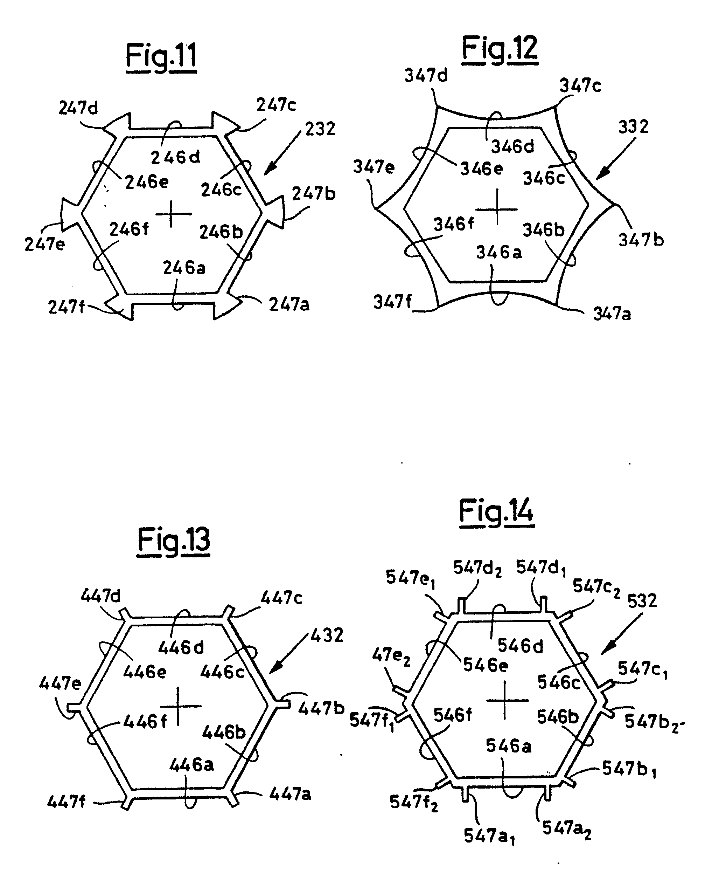

An explanation of this phenomenon depicted in figures 9a, 9B and 10A, 10B, can stand on the fact that in the contiguity of any corner between faces 146a-f and ridges l47a-f the flow rate of the gases is decreased by the presence of the ridge and is substantially null against the ridge; then it rises going away from said corner, having a maximum in a point intermediate between anyone of said corners and the center H of said faces.

Referring to figures 9A - 10A, with considerations similar to what above stated with respect to figures 5A, 5B, 6A, 6B, it is to deem that the flow rate profiles of the gases are more uniform, as depicted by figures 9A, 9B, 10A, 10B.

A susceptor in accordance with the principles of the invention can be made in a way different from that depicted in figure 8.

For example, the susceptor can have the cross-section shape depicted in figure 11 for a susceptor 232 provided with faces 246a-f, each other separated by protrusions or ridges 247a-f obtained from the material bulk of the susceptor, for example graphite, through mechanical working of the faces 246a-f.

Alternatively, the susceptor can have the cross-section shape depicted in figure 12 for a susceptor 332 provided with reentering faces 346a-f each other separated by corners 347a-f, produced by the action of a milling wheel, circumference working, on the lateral surface of a cylindrical or conical block, of material usable in susceptors.

Further alternativey, the susceptor can have the cross-section shape depicted in figure 13 for a susceptor 432, wherein like the susceptor 132 in figure 8, are attached at the corners separating the faces 446a-f, protrusions or ridges 447a-f, being said protrusions or ridges possibly of the same material of the susceptor or also of completely different material, provided it is chemically compatible with the process.

As depicted in figure 14, the susceptor can have a cross-section shape as that of the susceptor 532 provided with faces 546a-f anyone of them surrounded by inserted protrusion or ridge pairs 547a1, 547a2, ..., 547f1, 547f2.

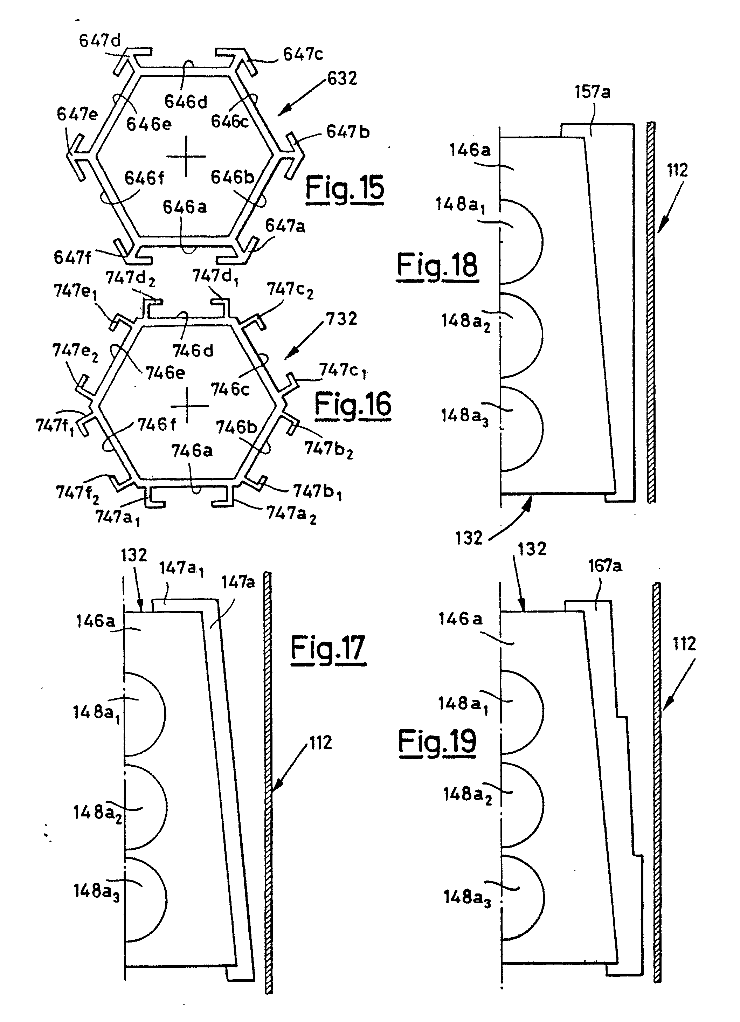

In a further susceptor 632, depicted in figure 15, among faces 646a-f can be inserted protrusions or ridges 647a-f provided with lateral protrusions enhancing the gas flow rate uniformity along the lateral faces thereof.

Also in the susceptor depicted in figure 16, among the faces 746a-f can be inserted protrusion or ridge pairs $747a_1$, $747a_2$, ..., $747f_1$, $747f_2$ provided with lateral internal protrusions enhancing the flow rate uniformity of the gases along the lateral faces thereof. The protrusions or ridges themselves at the lateral corners of the susceptor can have different arrangement.

For example, as depicted in figure 17, the protrusion or ridge 147a is arranged with the external edge parallel to the corresponding corner of the face 146a of the susceptor 132, while, as depicted in figure 18, the protrusion or ridge 157a is of variable thickness on the length thereof, in order to maintain its external edge parallel to the axis of the susceptor 132 and to the lateral wall of the belljair 112.

A specific effect here intended to be controlled is an epitaxial grow rate excess on the upper slices, such as the slice $148a_1$, probably due to the fact that said slices are exposed to the particularly fresh reacting gases because they have been just emitted by the distributor and did not even undergo any decomposition reaction. To remedy said grow rate excess, it is possible to think of extending the ridges 147a above the upper base of the susceptor by means of protrusions, such as the protrusion $147a_1$ in figure 17, extending to the central axis of the susceptor, said protrusions having the duty to slow down the flow rate of the gases near the top of the susceptor and thus near the upper slices themselves.

Generally, as depicted in figure 19, the protrusion or ridge 167a can be provided with one or a plurality of external edges shaped in a proper way similar to the heredepicted one, having found that by various empirically determined shapes can be obtained particular epitaxial grow rates producing particularly appreciable reuslts in the obtained products.

What has been here above disclosed, depicts specific embodiments of the present invention and people skilled in the art can devise provisions obvious and equivalent with respect to those here disclosed, all to be considered in the scope of the invention.

## Claims

1. System for controlling epitaxial grow rate in reactors using a susceptor (132) of the kind of a frustum pyramid, having polygonal basis, contained in a belljair (112), through control of flow rate of reacting gases around said susceptor (132), characterized in that it is to seek to render the most possible uniform said flow rate on lateral faces (146a-f) of said susceptor (132) at corners defined by adjacent lateral faces, by providing solid obstacles under the form of corner ridges (147a-f) protruding from said lateral edges of said susceptor (132).

2. System, as in claim 1, characterized in that a frustum pyramid susceptor (232) is provided with protrusions or ridges (247a-f) integrally formed in the bulk of said susceptor (232) digging by planar milling some faces (246a-f) along the lateral surface of a frustum cone making the starting piece of said susceptor.

3. System, as in claim 1, characterized in that a substantially frustum pyramid susceptor(332) is obtained by lateral milling of curved faces (346a-f) on a substantially frustum cone strating piece to make integral protruding ridges (347a-f).

4. System, as in claim 1, characterized in that to substantially uniform the reacting gas flow near corners delimitating lateral faces (446a-f) of frustum pyramid susceptors (432) protrusions or ridges (447a-f), however attached to individual corners, separating said lateral faces (446a-f), are used.

5. System, as in claim 4, characterized in that said protrusions or ridges (447a-f) are made of the same material of said susceptor (432).

6. System, as in claim 4, characterized in that said protrusions or ridges (447a-f) are made of material different from that of said susceptor (432), provided it is chemically compatible with the reactions happening in the reactors.

7. System, as in claim 1, characterized in that a frustum pyramid susceptor (532) is provided near any corner, separating adjacent lateral faces (546a-f) with protrusion or ridge pairs ($547a_1$, $547a_2$,..., $547f_1$, $547f_2$) delimitating said faces (546a-f) and however attached thereto.

8. System, as in claims 1 and 4, characterized in that a frustum pyramid susceptor (632) is provided near any corner separating adjacent lateral faces (646a-f), with protrusions or ridges (647a-f) provided with lateral protrusions parallel to said faces (646a-f) to support the flow rate uniformity of reacting gases along said lateral faces of said susceptor (632), said protrusions being attached to said corners separating the faces.

9. System, as in claims 1 and 7, characterized inthat a frusutm pyramid susceptor (732) is provided near any corner, separating adjacent lateral faces (746a-f), with pairs of protrusions or ridges ($747a_1$, $747a_2$, ..., $747f_1$, $747f_2$), delimitating said faces (746a-f), provided with lateral protrusions parallel to said faces (746a-f) to support the uniformity of the flow rate of reacting gases along said lateral faces of the susceptor (732), said protrusion pairs being located on the lateral faces (746a-f) themselves.

10. System, as in claims 1 to 9, characterized in that said protrusions dr ridges (147a-f) are arranged with their external edges parallel to the corresponding corners separating lateral faces (146a-f) of said frustum pyramid sucseptor (132) or parallel to the faces (146a-f) themselves.

11. System, as in claims 1 to 9, characterized in that said protrusions or ridges (57a-f), coming out from the corners separating the lateral faces (146a-f) of said susceptor (132), are of variable thickness, so that their external edges remain parallel to the axis of the susceptor (132) and to the lateral wall of the belljair (112).

12. System, as in claims 1 to 9, characterized in that said protrusions or ridges (167a-f), coming out from the corners separating the lateral faces (146a-f) of said susceptor (132), are provided with a plurality of external edges whose shape is empirically determined to allow the control of the epitaxial grow rate in said ractor according to desired profiles.

13. System, as in claim 12, characterized in that said protrusions or ridges (167a-f), coming out from the corners separating the lateral faces (146a-f) of said susceptor (132), are provided with a plurality of external edges subsantially parallel to the lateral wall of the belljair (112), arranged according to a staircase.

14. Sysstem, as in claims 1 to 9, characterized in that said ridges (147a-f) are extended above the upper base of the susceptor (132) by means of protrusions ($147a_1$-$f_1$), extending to the central axis of said suscetpor, having the duty to slow down the gas flow near the top of the susceptor.

**Fig.1**

**Fig.2**

Fig.3

Fig.7

Fig. 4

Fig.6A

Fig.5A

Fig.6B

Fig.5B

Fig.8

Fig.9A

Fig.10A

Fig.9B

Fig.10B

## Fig.11

247d · 247c · 232
246d
246e · 246c · 247b
247e · 246f · 246b
246a
247f · 247a

## Fig.12

347d · 347c
346d · 332
347e · 346e · 346c
346f · 346b · 347b
346a
347f · 347a

## Fig.13

447d · 447c · 432
446d
446e · 446c
447e · 446f · 447b
446b
446a
447f · 447a

## Fig.14

547e₁ · 547d₂ · 547d₁ · 547c₂ · 532
546d
47e₂ · 546e · 546c · 547c₁
547f₁ · 546f · 546b · 547b₂
546a · 547b₁
547f₂ · 547a₁ · 547a₂

**Fig.15**

**Fig.16**

**Fig.17**

**Fig.18**

**Fig.19**

## European Patent Office

# EUROPEAN SEARCH REPORT

Application Number

**EP 90 11 5689**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | US-A-4 638 762 (M.Y. KIM et al.)<br>* Claim 1; figure 2 *<br>— — — | 1 | C 30 B 25/14<br>C 23 C 16/44 |
| A | GB-A-2 181 460 (EPSILON LTD PARTNERSHIP)<br>* Abstract; figures 1a,1b,1c *<br>— — — | 1 | |
| A | US-A-4 322 592 (J.G. MARTIN)<br>* Abstract; figure 4; column 4, lines 59-65 *<br>— — — | 1 | |
| A | DE-A-3 838 164 (SUMITOMO CHEMICAL CO., LTD)<br>* Abstract *<br>— — — | 1 | |
| A | EP-A-0 131 208 (ULTRA CARBON CORP.)<br>— — — — — | | |

| | |
|---|---|
| | **TECHNICAL FIELDS SEARCHED (Int. Cl.5)** |
| | C 30 B<br>C 23 C |

The present search report has been drawn up for all claims

| Place of search | Date of completion of search | Examiner |
|---|---|---|
| The Hague | 14 November 90 | GREGG N.R. |